# EUROPEAN PATENT APPLICATION

(11) **EP 4 543 159 A1**
(43) Date of publication of application: **23.04.2025**
(21) Application number: 24185999.0
(22) Date of filing: 02.07.2024
(51) Int. Cl.: H05K 9/00

(54) **STRUCTURE BLOCKING ELECTROMAGNETIC WAVES**

(30) Priority: 18.10.2023 JP 2023179506
(71) Applicant: Cognitive Research Labs, Inc., Tokyo 1060032 (JP)
(72) Inventor: TOMABECHI, Hideto, Tokyo 106-0032 (JP)
(74) Representative: Winter, Brandl - Partnerschaft mbB

(57) **Abstract**

A structure blocking electromagnetic waves (100) includes a first portion (110) comprised of a first material consisting of an electric conductor, and a second portion (120) comprised of a second material having an electrical conductivity smaller than the same of the first material and a corrosion-resistance higher than the same of the first material, the second portion (120) covering therewith at least a part of a surface of the first portion (110).

## Description

### BACKGROUND OF THE INVENTION

### FIELD OF THE INVENTION

The present invention relates to a structure blocking electromagnetic waves or not allowing electromagnetic waves to pass therethrough. The present invention further relates to a system for blocking electromagnetic waves, employing the structure. The structure blocking electromagnetic waves is a material of which a Faraday cage is comprised.

### DESCRIPTION OF THE RELATED ART

A lot of problems has taken place recently due to electromagnetic waves (external electromagnetic waves).

For instance, noises of electromagnetic waves derived from various apparatuses cause malfunction in electronic devices.

Regarding international situation, a risk of an attack by EMP (electromagnetic pulse) cannot be ignored. Electronic devices go unusable in many cases by EMP attack.

In addition, there has been recently caused a problem of ETC (electronic toll collection system) malfunction in a toll gate in a toll road. Specifically, when a plurality of large-size vehicles continuously passes a traffic lane for ETC, there is caused a problem that it is sometimes impossible to accurately judge whether they pass or not. It is presumed that this problem is brought by unintentional reflection of electric waves.

Furthermore, it is necessary to shut out electromagnetic waves leaking out of electronic devices. If those electric waves having leaked out of electronic devices are detected and analyzed, there is caused another problem of information leakage.

One of countermeasures to electric-wave problems is so-called Faraday cage having been well known.

Faraday case indicates a case or a cage made of an electric conductor, or a space surrounded with such a case or a cage.

Since electric line of force cannot penetrate an internal space surrounded with an electric conductor, an external electric field is shut out of the internal space. Specifically, since electric charges are rearranged in the internal space so as to cancel an external electric field, the electric field becomes zero.

For instance, Japanese Patent Application Publications H9-257948 and S62-36565 have suggested usage examples of Faraday cage.

A metal is frequently used as an electric conductor of which Faraday cage is made.

However, since a metal has a small resistance against corrosion, it is not suitable to use Faraday cage made of a metal outdoors because of rain.

### SUMMARY OF THE INVENTION

In view of the above-mentioned problems of Faraday cage, it is an exemplary object of the present invention to provide a structure blocking electromagnetic waves as a constituent of Faraday cage for reinforcing disadvantages of conventional Faraday cage. It is further an exemplary object of the present invention to provide a system blocking electromagnetic waves, employing the above-mentioned structure.

In a first exemplary aspect of the present invention, there is provided a structure blocking electromagnetic waves (100), including a first portion (110) comprised of a first material consisting of an electric conductor, characterized by a second portion (120) comprised of a second material having an electrical conductivity smaller than the same of the first material and a corrosion-resistance higher than the same of the first material, the second portion (120) covering therewith at least a part of a surface of the first portion (110).

It is preferable that the first portion (110) has a first surface (111) exposed to electromagnetic waves, and a second surface (112) located in the other side of the first surface (111), the second portion (120) covering therewith at least the first surface (111) among the first and second surfaces (111, 112).

It is preferable that at least the second portion (120A) among the first and second portions (110, 120) has a meshed structure.

It is preferable that the second portion (120B) includes at least two auxiliary mesh materials (120X, 120Y) each having a mesh pattern different from others, the second portion (120B) covering therewith the first portion (110) in such a condition that the auxiliary mesh materials (120X, 120Y) are stacked one on another.

It is preferable that the second portion (120, 120C) has a first surface covering a surface (111) of the first portion (110) therewith, and a second surface located in the other side of the first surface, the second surface being formed with convexes/concaves (113) or being wavy.

It is preferable that at least one of a surface of the first portion (110) at which the first portion (110) makes contact with the second portion (120), and an outer surface of the second portion (120) has a surface roughness having a maximum height or a maximum depth shorter than a wavelength of external electromagnetic waves.

It is preferable that the first portion (110A) is in the form of a bar or a line, and the second portion (120D) covers therewith a peripheral surface of the first portion (110A).

It is preferable that the first material is one of gold, silver and copper.

It is preferable that the second material is one of stainless steel and titanium.

It is preferable that the second material does not allow electromagnetic waves to reflect, and allows electromagnetic waves to pass therethrough.

It is preferable that the second material is one of glass and resin.

It is preferable that the first portion (110C) is formed with convexes/concaves (113) at a surface at which the first portion (110C) makes contact with the second portion (120), has a meshed structure, or has a curved surface at which the first portion (110B) makes contact with the second portion (120).

It is preferable that the second material is resin.

It is preferable that at least one of a surface of the first portion (110C), the other surface of the first portion (110C), and an outer surface of the second portion (120C) is formed with convexes/concaves (113, 122) for electromagnetic waves to randomly reflect, a height or a depth of the convexes/concaves (113, 122) being in the range of 1/10 to 1/50 both inclusive of a wavelength of external electromagnetic waves.

It is preferable that the structure (100) further includes a ground wire (130) for grounding the first portion (110).

It is preferable that the structure is in the form of a panel, the panel including at sides thereof a convex (101) and a concave (102) through which the panel (100C) is connected with neighboring panel(s).

In a second exemplary aspect of the present invention, there is provided a system for blocking electromagnetic waves to be equipped on a traffic lane on which an electronic toll collection system is formed, characterized in that the system includes at least one of a first electromagnetic-wave blocking structure (300, 350) formed between the traffic lane (201) and a second traffic lane (202) neighboring the traffic lane (201) and a second electromagnetic-wave blocking structure (360) formed short of an on-road antenna (210) in a direction in which a vehicle (251) runs in the traffic lane (201), the on-road antenna (210) being formed above the traffic lane (201), the first electromagnetic-wave blocking structure (300, 350) prevents electric waves transmitted from an on-road antenna (210A) located above the second traffic lane (202) and reflected from a vehicle (252) driving on the second traffic lane (202), from reaching an on-road antenna (210) located in the traffic lane (201), the second electromagnetic-wave blocking structure (360) is located within a path in which electric waves having been transmitted from the on-road antenna (210), being able to reach a precedent vehicle (251), and having been reflected from a vehicle (253) following the precedent vehicle (251) head to the on-road antenna (210), and the first and second electromagnetic-wave blocking structures (300, 350, 360) are comprised of the above-mentioned structure (100).

It is preferable that the electromagnetic-wave blocking structure (300, 350) has a length equal to or greater than a length of a large-size vehicle.

It is preferable that the electromagnetic-wave blocking structure is in the form of a wall (300).

It is preferable that the wall (300) has a height higher than the on-road antenna (210) transmitting electric waves to a vehicle (251) driving on the traffic lane (201).

It is preferable that the wall (300) has such a length along the traffic lane (201) that the on-road antenna (210) formed on the traffic lane (201) is located within the wall (300).

It is preferable that the electromagnetic-wave blocking structure is in the form of a tunnel (350) covering the traffic lane (201) therewith.

It is preferable that the tunnel (350) has such a length along the traffic lane (201) that the on-road antenna (210) formed on the traffic lane (201) is located within the tunnel (350).

### ADVANTAGES OBTAINED BY THE INVENTION

In the structure in accordance with the present invention, the second material has a corrosion-resistance higher than the same of the first material. Accordingly, in comparison with Faraday cage made of the first portion consisting only of the first material, Faraday cage made of the structure can have a higher resistance against outdoor environment in which water and other elements for corrosion exist. Thus, Faraday cage made of the structure in accordance with the present invention is more suitable to outdoor use than conventional Faraday cage.

The system in accordance with the present invention can prevent interference in electric waves between on-road antennas located in two traffic lanes adjacent to each other, and hence, can prevent malfunction of ETC caused by such interference in electric waves.

### BRIEF DESCRIPTION OF THE DRAWINGS

FIG. 1 is a perspective view of an electromagnetic-wave blocking structure in accordance with the first exemplary embodiment.
FIG. 2 is a plan view of a first modification of a second portion of which the electromagnetic-wave blocking structure is comprised.
FIG. 3 is a plan view of a second modification of a second portion of which the electromagnetic-wave blocking structure is comprised.
FIG. 4A is a plan view of a third modification of a second portion of which the electromagnetic-wave blocking structure is comprised.
FIG. 4B is a side view of FIG. 4A.
FIG. 5 is a perspective view of an electromagnetic-wave blocking structure in accordance with the second exemplary embodiment.
FIG. 6 is a perspective view of an electromagnetic-wave blocking structure in accordance with the third exemplary embodiment.
FIG. 7 is a perspective view of an electromagnetic-wave blocking structure in accordance with the fourth exemplary embodiment.
FIG. 8 is a cross-sectional view of a first portion in a first example of an electromagnetic-wave blocking structure in accordance with the fifth exemplary embodiment.
FIG. 9 is a cross-sectional view of a first portion in a second example of an electromagnetic-wave blocking structure in accordance with the fifth exemplary embodiment.
FIG. 10 is a perspective view of a toll gate of a toll road with which ETC is equipped.
FIG. 11 is a front view of a first example of an electromagnetic-wave blocking system in accordance with the sixth exemplary embodiment.
FIG. 12 is a front view of a second example of an electromagnetic-wave blocking system in accordance with the sixth exemplary embodiment.
FIG. 13 is a side view showing a positional relation among an on-road antenna, a precedent vehicle and a following vehicle in an electromagnetic-wave blocking system in accordance with the seventh exemplary embodiment.
FIG. 14 is a view of FIG. 13 when viewed from the top.

### DESCRIPTION OF THE EXEMPLARY EMBODIMENTS

Exemplary embodiments in accordance with the present invention will be explained hereinbelow with reference to drawings.

### (First Exemplary Embodiment)

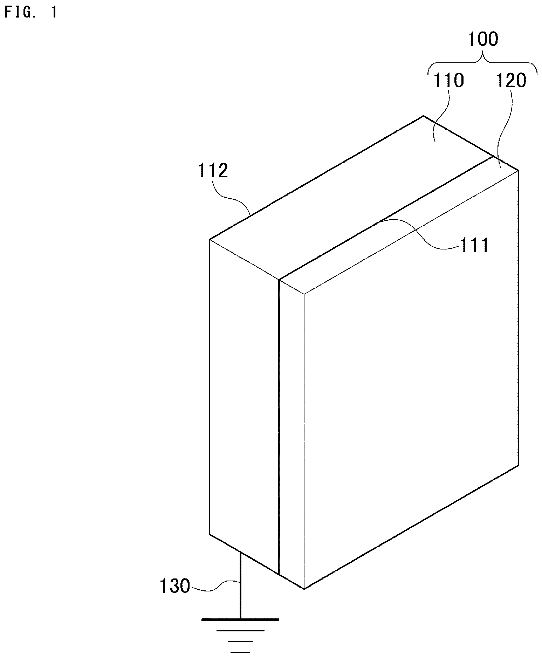

FIG. 1 is a perspective view of an electromagnetic-wave blocking structure 100 in accordance with the first exemplary embodiment of the present invention.

The electromagnetic-wave blocking structure 100 includes a first portion 110 made of a first material, a second portion 120 made of a second material, and a ground (earth) wire 130 grounding the first portion 110.

The first portion 110 is cubic in shape.

The first material of which the first portion 110 is made is an electrical conductor. For instance, the first material is a metal. Specifically, the first material is a metal having a high electrical conductivity, such as gold, silver and copper.

The second portion 120 is in the form of a flat board having a constant thickness.

The second material of which the second portion 120 is made has both an electrical conductivity smaller than the same of the first material and a corrosion-resistance higher than the same of the first material. For instance, the second material is stainless steel or titanium.

The cubic first portion 110 has a first surface 111 and a second surface 112 located at the other side of the first surface 111.

In such a circumference that the electromagnetic-wave blocking structure 100 is exposed to electromagnetic waves, for instance, supposing that the first portion 110 is exposed at the first surface 111 to electro-magnetic waves, the second portion 120 is designed to entirely cover therewith the first surface 111 of the first portion 110.

A part of external electromagnetic waves having irradiated the second portion 120 is reflected at a surface of the second portion 120. The rest of the electromagnetic waves passes through the second portion 120, irradiates the first portion 110, and released to ground through the ground wire 130. That is, it is possible to prevent electromagnetic wave from leaking outside by grounding the first portion 110.

As a result, external electromagnetic waves cannot pass through the electromagnetic-wave blocking structure 100. It apparently seems that external electromagnetic waves are absorbed into the electromagnetic-wave blocking structure 100. This is called absorption effect.

The second material has a corrosion-resistance higher than the same of the first material. Accordingly, in comparison with conventional Faraday cage made of the first portion consisting only of the first material, Faraday cage made of the structure 100 can have a higher resistance against outdoor environment in which water and other elements for corrosion exist. Thus, Faraday cage made of the electromagnetic-wave blocking structure 100 is more suitable to outdoor use than conventional Faraday cage.

The electromagnetic-wave blocking structure in accordance with the first exemplary embodiment is not to be limited to the above-mentioned structure, but can have various modifications.

Though the electromagnetic-wave blocking structure 100 is designed to include the ground wire 130, it is not always necessary for the electromagnetic-wave blocking structure 100 to originally include the ground wire 130.

For instance, the electromagnetic-wave blocking structure 100 is first constructed without including the ground wire 130, and then, the ground wire 130 may be additionally set up at a site where Faraday cage made of the electromagnetic-wave blocking structure 100 is put for connecting the first portion 110 to ground.

Though the first portion 110 is designed to be cubic in shape, the first portion 110 may be designed to have any shape.

In the first exemplary embodiment, the second portion 120 is designed to entirely cover therewith the first surface 111 of the first portion 110. As an alternative, the second portion 120 may be designed to partially cover therewith the first surface 111 of the first portion 110.

For instance, in a particular environment in which electromagnetic waves are focused to a part of the first surface 111 of the first portion 110, the second portion 120 may be designed to cover therewith only the part of the first surface 111.

The second material of which the second portion 120 was exemplified to be stainless steel or titanium in the first exemplary embodiment. Even if measures are taken to a surface of the second portion 120 in order to prevent or reduce reflection, it is not possible to completely suppress generation of waves reflected at a surface of the second portion 120.

Thus, the second portion 120 may be made of a material at which electromagnetic waves are not reflected, but through which electromagnetic waves pass, for instance, a glass or a resin. Electromagnetic waves pass through the second portion 120 made of a glass or a resin, then are absorbed into the first portion 110, and thereafter, released into ground through the ground wire 130.

The second portion 120 is designed to be in the form of a flat board in the first exemplary embodiment, but the second portion 120 is not to be limited in shape to a flat board.

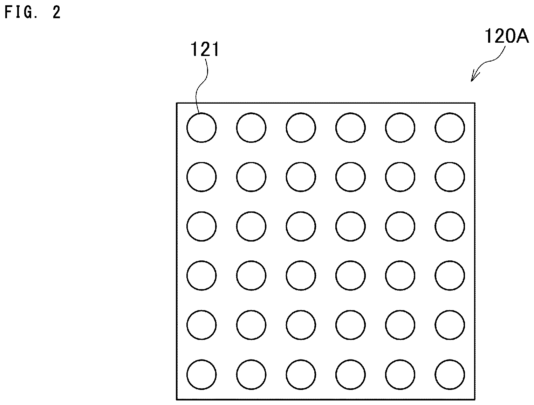

FIG. 2 is a plan view of a first modification of the second portion 120.

A second portion 120A in accordance with the first modification is designed to be meshed. For instance, as illustrated in FIG. 2, the second portion 120A is formed with a plurality of same-sized holes 121 in a matrix.

By designing the second portion 120A to be meshed, it is possible to reduce a manufacturing cost by reducing a volume of the second portion 120A, accomplish a light weight, enhance a resistance against wind, and enhance visibility (a condition of the first portion 110 can be seen).

Any mesh pattern may be selected. For instance, the second portion 120A may be in the form of a net. Any mesh pattern can be selected in dependence of outdoor environment.

It is not always necessary for the holes 121 to have a diameter equal to one another. The holes 121 may have a diameter different from others. The holes 121 may be arranged not in a matrix, but randomly.

As an alternative, the first portion 110 may be designed to be meshed similarly to the second portion 120A as well as the second portion 120A. That is, the electromagnetic-wave blocking structure 100 may be designed to be entirely meshed, in which case, the first portion 110 and the second portion 120A may be designed to have a common mesh pattern or a mesh pattern different from each other.

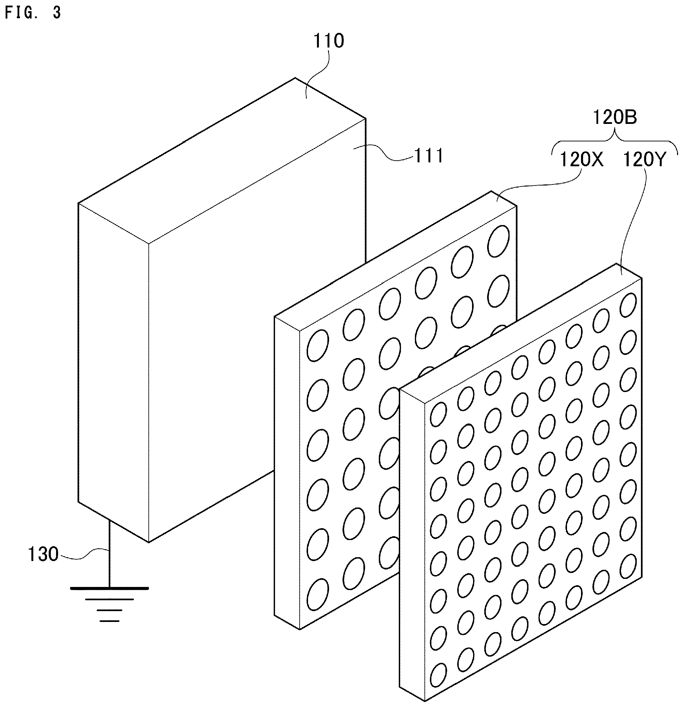

FIG. 3 is a perspective view of a second modification of the second portion 120.

As illustrated in FIG. 3, a second portion 120B in the second modification is designed to be comprised of a first auxiliary portion 120X and a second auxiliary portion 120Y

The first auxiliary portion 120X is identical with the second portion 120A illustrated in FIG. 2.

The second auxiliary portion 120Y has a mesh pattern in which a plurality of holes are formed in a matrix. A diameter of the holes of the second auxiliary portion 120Y and a distance (pitch) between the adjacent holes are different from those of the first auxiliary portion 120X.

That is, both the first and second auxiliary portions 120X and 120Y have a meshed structure, but mesh patterns of them are different from each other.

As illustrated in FIG. 3, the first and second auxiliary portions 120X and 120Y are stacked one on another to thereby cover therewith the first surface 111 of the first portion 110. Specifically, the first auxiliary portion 120X covers therewith the first surface 111 of the first portion 110, and the second auxiliary portion 120Y covers therewith a surface of the first auxiliary portion 120X.

Which mesh pattern is effective to external electromagnetic waves varies in dependence on external factors such as physical properties (amplitude, wavelength and so on) and incident angle of external electromagnetic waves. Thus, it is possible to enhance effectiveness of blocking various electromagnetic waves by employing the two auxiliary portions 120X and 120Y each having a mesh pattern different from each other.

The second portion 120B is designed to be comprised of the two auxiliary portions 120X and 120Y, but a number of the auxiliary portions comprising the second portion 120B is not to be limited to two. The second portion 120B may be designed to be comprised of three or more auxiliary portions. The second portion 120B comprised of a greater number of the auxiliary portions can have a higher effectiveness for blocking various electromagnetic waves.

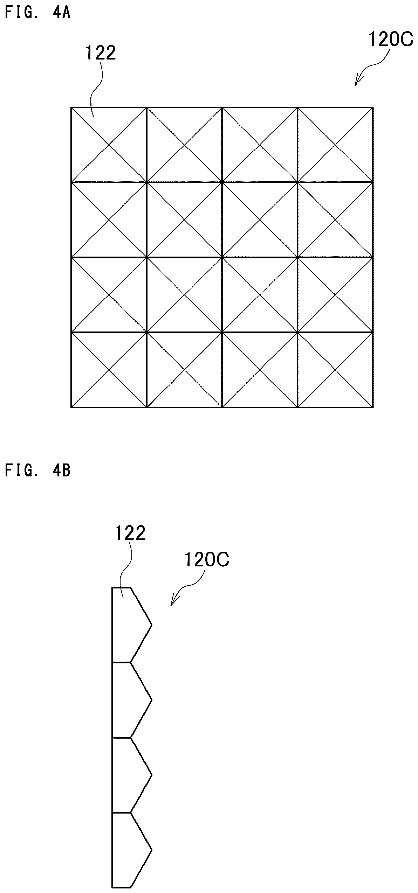

FIG. 4A is a plan view of a third modification of the second portion 120, and FIG. 4B is a side view of the same.

As illustrated in FIGs. 4A and 4B, a second portion 120C in accordance with the third modification is formed at an outer surface (a surface located at the other side of a surface at which the second portion 120C makes contact with the first portion 110) with a plurality of convexes or projections 122. The convexes 122 have the same shape as one another and are arranged in a matrix.

The convexes 122 are in the shape of a square pyramid.

External electromagnetic waves are partially reflected at the second portions 120, 120A and 120B illustrated in FIGs. 1 to 3. By designing the second portion 120C to have the convexes 122 at an outer surface thereof, it is possible to cause electromagnetic waves to be randomly reflected (diffused), ensuring it possible to prevent energy caused by reflection from spreading.

A shape of the convexes 122 is not to be limited to a square pyramid. The convexes 122 may be designed to have any shape. In addition, it is not always necessary for all of the convexes 122 to have the same shape, but at least some of the convexes 122 may have a shape different from shapes of others.

The second portion 120C may be designed to have concaves in place of the convexes 122 or designed to have a combination of concaves and the convexes 122.

As an alternative, the second portion 120C may be designed to have a wavy surface in place of the convexes 122.

In order to cause electromagnetic waves to be randomly reflected by means of convexes/concaves, it is said that the convexes/concaves have a height/depth in the range of about 1/10 to about 1/50 of a wavelength of electromagnetic waves. For instance, an ultraviolet ray has the shortest wavelength among external electromagnetic waves (electric waves existing in natural environment). Specifically, an ultraviolet ray has a wavelength in the range of about 10 to about 200 nanometers. Accordingly, the convexes/concaves are designed to have a height/depth in the range of about 2 to about 10 nanometers for a ultraviolet ray.

It is preferable that, when the first surface 111 of the first portion 110, the second surface 112 of the first portion 110 or an outer surface of the second portion 120 (a surface located at the other side of a surface at which the second portion 120 makes contact with the first surface 111 of the first portion 110) is formed with convexes/concaves for causing external electromagnetic waves to be randomly reflected, the convexes/concaves have a height/depth in the range of about 1/10 to about 1/50 of a wavelength of electromagnetic waves.

### (Second Exemplary Embodiment)

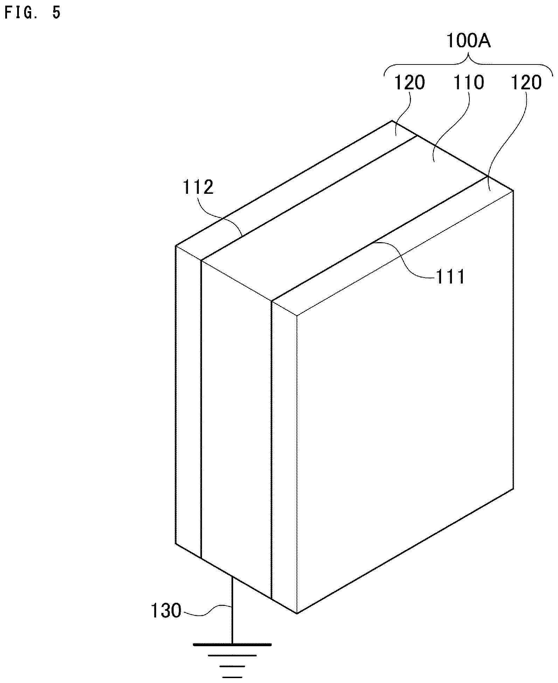

FIG. 5 is a perspective view of an electromagnetic-wave blocking structure 100A in accordance with the second exemplary embodiment of the present invention.

In the electromagnetic-wave blocking structure 100 illustrated in FIG. 1, the second portion 120 is designed to cover therewith only one of surfaces (the first surface 111) of the first portion 110. In contrast, the second portion 120 covers therewith opposite surfaces (the first surface 111 and the second surface 112) of the first portion 110 in the electromagnetic-wave blocking structure 100A.

By designing the second portion 120 to cover therewith both the first and second surfaces 111, 112 of the first portion 110, it is possible to enhance both a capability of absorbing electromagnetic waves and a resistance against outdoor environment, and further, it is no longer necessary to take into consideration which direction the electromagnetic-wave blocking structure 100A faces. That is, it was necessary in the electromagnetic-wave blocking structure 100 to direct the second portion 120 so as to be exposed to external electromagnetic waves, but it is no longer necessary in the electromagnetic-wave blocking structure 100A to do so, because the first portion 110 is covered at opposite sides with the second portion 120.

### (Third Exemplary Embodiment)

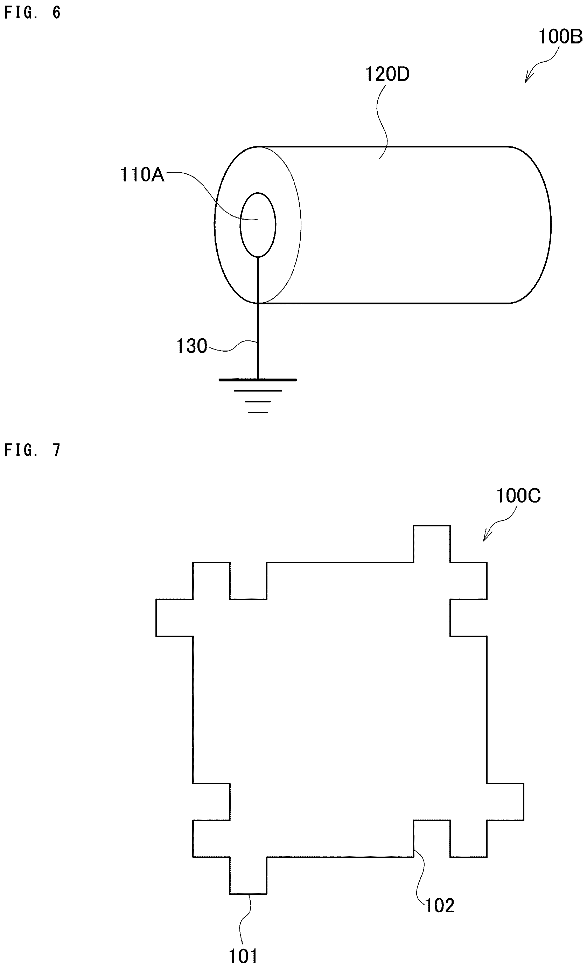

FIG. 6 is a perspective view of an electromagnetic-wave blocking structure 100B in accordance with the third exemplary embodiment of the present invention.

In the third exemplary embodiment, a first portion 110A is in the form of a rod (bar) or a wire, and a second portion 120D is designed to cover therewith a circumferential surface of the first portion 110A.

The electromagnetic-wave blocking structure 100B provides the same advantages as those provided by the electromagnetic-wave blocking structure 100.

By weaving the electromagnetic-wave blocking structure 100B being in the form of a wire, a meshed electromagnetic-wave blocking structure can be obtained.

It is possible to realize an electromagnetic-wave blocking structure, as shown in the present exemplary embodiment, although the first portion 110 is not in the form of a flat board (see FIG. 1), but is in the form of a rod or a wire.

### (Fourth Exemplary Embodiment)

FIG. 7 is a perspective view of an electromagnetic-wave blocking structure 100C in accordance with the fourth exemplary embodiment of the present invention.

The electromagnetic-wave blocking structure 100C is formed by designing the electromagnetic-wave blocking structure 100 as a square panel, for instance.

The panel 100C (the electromagnetic-wave blocking structure 100C) is designed to have a convex portion 101 and a concave portion 102 in each of four peripheral sides at a common position. Both the convex portion 101 and the concave portion 102 is cubic in shape, and the convex portion 101 is fittable into the concave portion 102.

The panel 100C and a panel (not illustrated) located adjacent to the panel 100C can be connected with each other by fitting the convex portion 101 and the concave portion 102 of the panel 100C into the concave portion 102 and the convex portion 101 of the adjacent panel, respectively.

Thus, it is possible to connect a required number of the panels 100C with one another by designing the panel 100C to have the convex portion 101 and the concave portion 102 at each of four sides.

The convex portion 101 and the concave portion 102 may be designed to have any shape as long as the convex portion 101 is fittable into the concave portion 102.

### (Fifth Exemplary Embodiment)

The first portion 110 is sometimes unable to entirely absorb electromagnetic waves having passed through the second portion 120, and thus, partially reflect the electromagnetic waves. In the present exemplary embodiment, the first portion 110 is designed to have such a shape that can cope with this problem in place of the above-mentioned flat board.

In the fifth exemplary embodiment, the first portion 110 is designed to have such a structure that randomly reflects electromagnetic waves which have not been absorbed into the first portion 110.

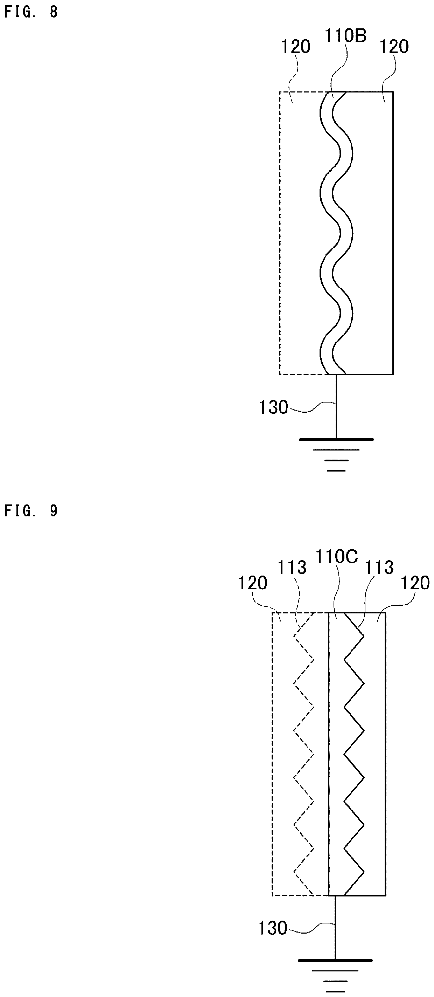

FIG. 8 is a cross-sectional view of a first portion 110B in accordance with the first example of the fifth exemplary embodiment.

The first portion 110B has a wavy surface at which the first portion 110B makes contact with the second portion 120. Most of electromagnetic waves having passed through the second portion 120 is absorbed into the first portion 110B, and then, is discharged to ground through the ground wire 130. Electromagnetic waves having not been absorbed into the first portion 110B are caused to randomly reflect at the wavy surface of the first portion 110B, and then, are attenuated.

It is possible to effectively cope with electromagnetic waves having passed through the second portion 120, by designing the first portion 110B to have a wave surface.

A shape of the first portion 110B is not to be limited to be wavy. The first portion 110B may have any shape, if it is curved. In addition, it is not always necessary for the first portion 110B to be regularly curved as illustrated in FIG. 8, but the first portion 110B may be curved irregularly.

In the case that the first portion 110B is designed to be wavy in shape, a second material of which the second portion 120 is made is preferable a resin. If a glass or a metal is selected as a second material, the second portion 120 is necessary to have a shape in line with a wavy shape of the first portion 110B. If a resin is selected as a second material, it is possible to make the second portion 120 merely by coating a liquid resin onto a wavy surface of the first portion 110B, and drying the resin, ensuring much reducing steps of manufacturing the second portion 120.

As shown with a broken line in FIG. 8, the first portion 110B may be covered at opposite surfaces thereof with the second portions 120.

FIG. 9 is a cross-sectional view of a first portion 110C in accordance with the second example of the fifth exemplary embodiment.

The first portion 110C is regularly formed at a surface thereof (the first surface 111 in FIG. 1) at which the first portion 110C makes contact with the second portion 120, with convexes 113 similar in structure to the convexes 122 illustrated in FIG. 4.

Similarly to the first portion 110B having a wavy surface, electromagnetic waves having not been absorbed into the first portion 110C are caused to randomly reflect at the convexes 113 formed on a surface of the first portion 110C, and then, are attenuated.

Similarly to the convexes 122, the convexes 133 may be designed to have any shape. The first portion 110C may be designed to have concaves in place of the convexes 113, or have a combination of the convexes 113 and concaves.

Similarly to the first example illustrated in FIG. 8, it is preferable to select a resin as a second material of which the second portion 120 is made.

As shown with a broken line in FIG. 9, the first portion 110C may be designed to include the convexes 113 at a surface (the second surface 112 in FIG. 1) located at the other side of the surface on which the convexes 113 are formed, in which case, the convexes 113 may be covered with the second portion 120 made of a resin.

As a third example, the first portion 110 may be designed to be meshed, similarly to the second portion 120A (see FIG. 2).

By designing the first portion 110 to be meshed, it is possible to cause electromagnetic waves having not been absorbed into the firsts portion 110 to randomly reflect to thereby be attenuated, similarly to the first portion 110B having a wavy surface.

As a fourth example, the first portion 110 may be formed on the first surface 111 with minute convexes/concaves or the first surface 111 may be designed to be gritty.

For instance, an ultraviolet ray has a shortest wavelength among external electric waves (electric waves existing in natural environment). Specifically, an ultraviolet ray has a wavelength in the range of about 10 to about 200 nanometers. Accordingly, it is actually possible to reflect external electromagnetic waves, even if a relatively large projection such as the convexes 113 is not formed on the first surface 111 of the first portion 110.

That is, the first surface 111 of the first portion 110 may be designed to sufficiently have convexes/concaves having a height/depth shorter than a wavelength of external electromagnetic waves (for instance, a ultraviolet ray). In other words, it is possible to cause electromagnetic waves to randomly reflect to thereby be attenuated, if the first surface 111 has a surface roughness having a maximum height/depth shorter than a wavelength of external electromagnetic waves.

Similarly to the first example, a second material of which the second portion 120 is made is preferable a resin in the case that the first surface 111 is formed with minute convexes/concaves.

The first portion 110 may be formed at the opposite surfaces 111, 112 with minute convexes/concaves. The second portion 120 may be designed to have minute convexes/concaves on an outer surface.

### (Sixth Exemplary Embodiment)

The sixth exemplary embodiment relates to a first example of an electromagnetic-wave blocking system employing the above-mentioned electromagnetic-wave blocking structure 100, 100A or 100C.

As mentioned earlier, there has been caused a problem of ETC malfunction in a toll gate in a toll road. The electromagnetic-wave blocking system overcomes this problem.

ETC (Electronic Toll Collection system) generally comprises an on-road antenna situated above a toll gate in a toll road and an on-board ETC device equipped with a vehicle. A toll for passing a toll road is automatically paid by radiocommunication made between the on-road antenna and the on-board ETC device.

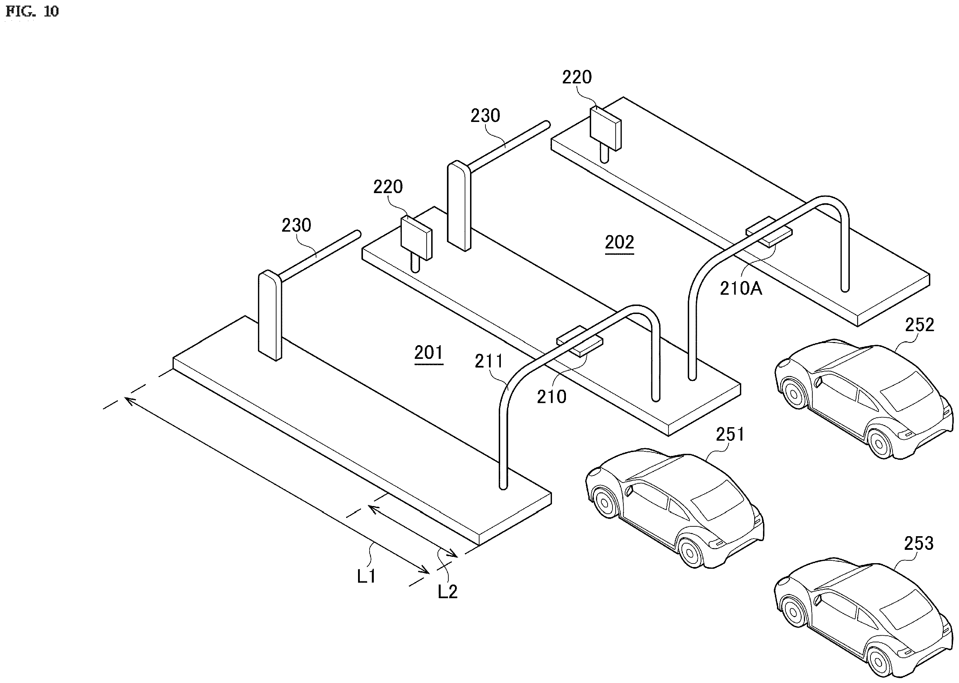

FIG. 10 is a perspective view of a toll gate in a toll road equipped with ETC.

For instance, a toll road includes a first traffic lane 201 and a second traffic lane 202 adjacent to the first traffic lane 201. A toll gate is set for each of traffic lanes. Hereinbelow is explained the first traffic lane 201 as an example.

ETC equipped in the first traffic lane 201 includes an on-road antenna 210 transmitting radio waves to an on-board ETC device equipped in a vehicle, a display panel displaying a toll, and a bar 230 opening or shutting the first traffic lane 210.

The on-road antenna 210 is supported by a stand 211 so as to straddle the first traffic lane 201. The on-road antenna 210 is located above and at the center of the first traffic lane 201, and downwardly transmits radio waves to a vehicle 251 driving in the first traffic lane 201.

When the vehicle 251 is identified by radio-wave communication made between the on-road antenna 210 and the on-board ETC device, a toll is displayed in the display panel 220. Until a toll is paid, the bar 230 is kept closed, and when a toll is paid, the bar 230 is open. When the vehicle 251 passes over the bar 230, the bar 230 is closed again.

As mentioned above, when a plurality of vehicles (particularly, large-size vehicles) continuously passes a traffic lane, there is caused a problem that ETC sometimes cannot accurately judge whether they pass or not. Hereinbelow is explained the reason presumed for this problem.

When the vehicle 251 driving in the first traffic lane 201 comes close to the on-road antenna 210, the on-road antenna 210 detects the vehicle 251, and transmits a radio wave to the vehicle 251. The on-board ECT device equipped in the vehicle 251 receives the radio wave having been transmitted from the on-road antenna 210, and then, transmits ID information to the on-road antenna 210 so that the on-road antenna 210 can identify the vehicle 251. The bar 230 is open after a toll was paid through radio-wave communication made between the on-road antenna 210 and the on-board ETC device.

It is supposed that when the vehicle 251 is coming close to the on-road antenna 210, a vehicle 252 driving in the second traffic lane 202 adjacent to the first traffic lane 201 is coming close to an on-road antenna 210A located above the second traffic lane 202.

The on-road antenna 210A located in the second traffic lane 202 transmits a radio wave to the coming vehicle 252, similarly to the on-road antenna 210. A part of radio waves having been transmitted from the on-road antenna 210A is received in the on-board ETC device of the vehicle 252, but a part of radio waves having not been received in the on-board ETC device sometimes reflects at the vehicle 252. A part of the reflected radio waves is received in the on-road antenna 210 located in the first traffic lane 201, resulting in that the on-road antenna 210 doubly receives both a radio wave having been transmitted from the on-board ETC device of the vehicle 251 and a radio wave having been reflected at the vehicle 252. The on-road antenna 210 resultingly judges double reception of radio waves as an error, and thus, the bar 230 is not open, but is kept closed. Thus, the vehicle 251 is not allowed to pass a toll gate.

As explained above, it is considered that the malfunction of ETC (ETC cannot accurately judge whether the vehicle 251 is allowed to pass a toll gate) is caused by the interference in radio waves of the on-road antennas 210 and 210A across the two traffic lanes 201 and 202 located adjacent to each other.

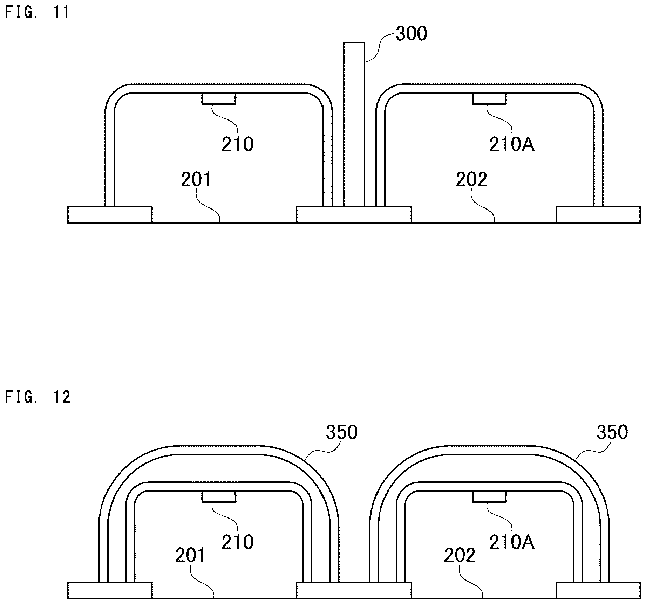

FIG. 11 is a front view of the electromagnetic-wave blocking system in accordance with a first example of the present exemplary embodiment.

The electromagnetic-wave blocking system in accordance with the first example is formed as an electromagnetic-wave blocking wall 300. The electromagnetic-wave blocking wall 300 vertically stands between the first traffic lane 201 and the second traffic lane 202.

The electromagnetic-wave blocking wall 300 causes electric waves having been reflected at the vehicle 252 driving in the second traffic lane 202 to be absorbed into or reflected at the electromagnetic-wave blocking wall 300, and thus, the reflected electric waves cannot reach the on-road antenna 210 located in the first traffic lane 201. Accordingly, the on-road antenna 210 receives only electric waves having been transmitted from the on-board ETC device of the vehicle 251 driving in the first traffic lane 201, ensuring that the above-mentioned double reception of electric waves is prevented to thereby prevent the malfunction of ETC.

Walls of a toll gate in ETC are sometimes covered with fibers being able to highly absorb electromagnetic wave therein. However, reflection of electromagnetic waves is prevented only at walls of a toll gate, and thus, it is not possible to prevent electromagnetic waves having been reflected at the second traffic lane 202 from reaching the on-road antenna 210 located in the first traffic lane 201, resulting in that the above-mentioned problem caused by the reflection of electromagnetic waves from the adjacent traffic lane cannot be overcome. It is necessary to construct the electromagnetic-wave blocking wall 300 in order to completely overcome the problem.

The electromagnetic-wave blocking wall 300 may be designed to have a length L1 (see FIG. 10) extending to the bar 230 from the on-road antenna 210, but preferably have a length L2 (see FIG. 10) within which the on-road antenna 210 is located (that is, a length across the on-road antenna 210), in which case, it is sufficient for the electromagnetic-wave blocking wall 300 to have a length covering a length of a vehicle, specifically, a length covering a length of a large-sized vehicle.

As illustrated in FIG. 11, it is preferable that the electromagnetic-wave blocking wall 300 has a height higher than a height of the on-road antenna 210.

By designing the electromagnetic-wave blocking wall 300 to have such a height, since electromagnetic waves having been reflected at the adjacent second traffic lane 202 cannot go over the electromagnetic-wave blocking wall 300 to enter the first traffic lane 201, the electromagnetic waves having been reflected at the adjacent second traffic lane 202 are entirely absorbed into or reflected at the electromagnetic-wave blocking wall 300, and thus, cannot reach the on-road antenna 210.

FIG. 12 is a front view of the electromagnetic-wave blocking system in accordance with a second example of the present exemplary embodiment.

The electromagnetic-wave blocking system in accordance with the second example is formed as a tunnel 350 constructed so as to cover therewith the first traffic lane 201.

Similarly to the electromagnetic-wave blocking wall 300, the tunnel 350 causes electric waves having been reflected at the vehicle 252 driving in the second traffic lane 202 to be absorbed into or reflected at the tunnel 350, and thus, the reflected electric waves cannot reach the on-road antenna 210 located in the first traffic lane 201. Accordingly, the on-road antenna 210 receives only electric waves having been transmitted from the on-board ETC device of the vehicle 251 driving in the first traffic lane 201, ensuring that the above-mentioned double reception of electric waves is prevented to thereby prevent the malfunction of ETC.

As illustrated in FIG. 12, the tunnel 350 is designed to have such a height that the on-road antenna 210 can be located within the tunnel 350.

Similarly to the electromagnetic-wave blocking wall 300, the tunnel 350 is located within at least the length L2, and the tunnel 350 has a length equal to or greater than a length of a large-sized vehicle.

The on-road antenna 210 is designed to transmit electric waves having a frequency of 5.8 GHz band in accordance with a predetermined standard (Standard DSRC).

As mentioned earlier, in order to cause external electromagnetic waves to randomly reflect or diffuse by means of surface roughness (convexes/concaves), it is said that surface roughness (convexes/concaves) needs to have a height/depth in the range of about 1/10 to about 1/50 of a wavelength of electromagnetic waves both inclusive. Electric waves of 5.8 GHz band has a wavelength of about 5.2 cm. Consequently, in the case that the electromagnetic-wave blocking wall 300 or the tunnel 350 is comprised of the electromagnetic-wave blocking structure including the first portion 110 and/or the second portion 120 formed with a surface thereof with the convexes 113 and 122, or the electromagnetic-wave blocking structure including the first portion 110 and/or the second portion 120 having a surface to which a predetermined surface roughness is applied, it is effective to design the convexes/concaves to have a height/depth in the range of 2 mm to 1 cm both inclusive.

### (Seventh Exemplary Embodiment)

The seventh exemplary embodiment relates to a second example of an electromagnetic-wave blocking system employing the above-mentioned electromagnetic-wave blocking structure 100, 100A or 100C.

The above-mentioned electromagnetic-wave blocking system in accordance with the sixth exemplary embodiment prevents a trouble caused by electric waves having been reflected at the adjacent second traffic lane 202 and having reached the on-road antenna 210 located in the first traffic lane 201. There is another reason causing such a trouble.

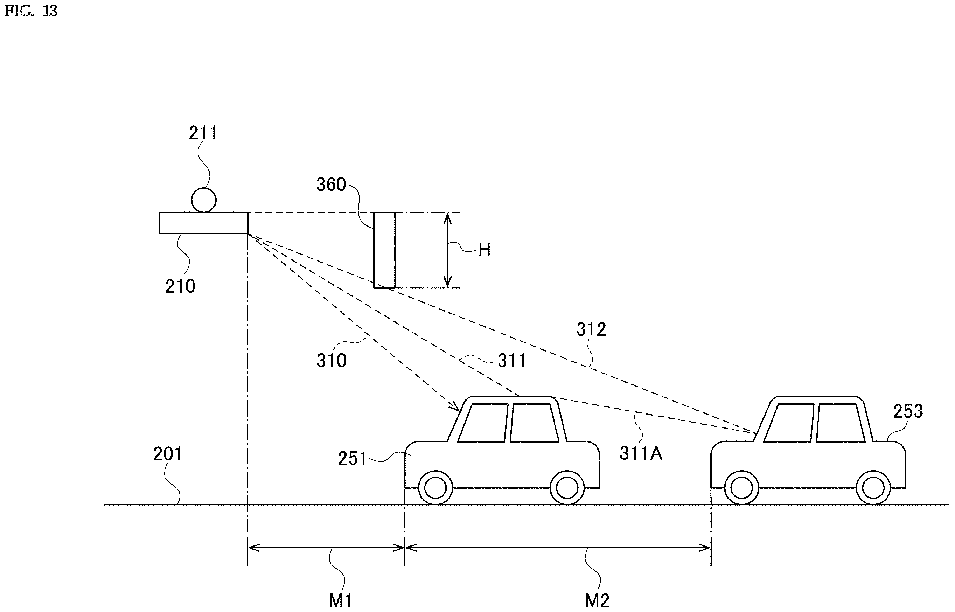

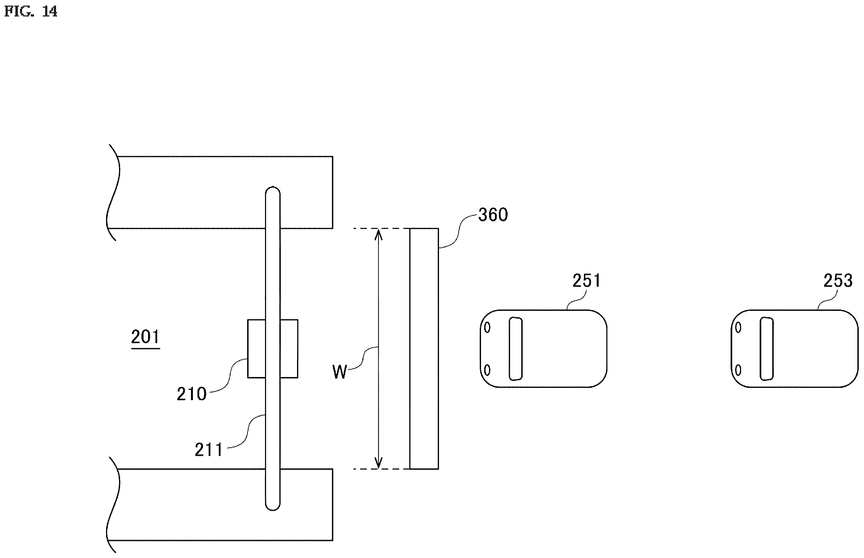

FIG. 13 is a side view showing a positional relation among the on-road antenna 210, the precedent vehicle 251 and the following vehicle 253, and FIG. 14 is a plan view of FIG. 13 when viewed from the top.

As illustrated in FIG. 13, a part 311 of electric waves 310 having been transmitted from the on-road antenna 210 to the vehicle 251 driving in the first traffic lane 201 is sometimes reflected at a body (for instance, a roof or a side body) of the vehicle 251, and then, reaches the following vehicle 253 as a reflection wave 311A. The reflection wave 311A is further reflected at a body of the following vehicle 253, and then, reaches the on-road antenna 210 as a reflection wave 312. Thus, the reflection wave 312 having come from the following vehicle 253 and reaching the on-road antenna 210 may cause a problem that the on-road antenna 210 cannot accurately judge whether a vehicle or vehicles pass(es) a toll gate.

The electromagnetic-wave blocking system in accordance with the present exemplary embodiment can overcome such a problem.

The electromagnetic-wave blocking system includes an electromagnetic-wave blocking wall 360 located before or ahead of the on-road antenna 210 in a direction in which the vehicle 251 is driving

Similarly to the electromagnetic-wave blocking wall 300 and the tunnel 350, the electromagnetic-wave blocking wall 360 is made of the electromagnetic-wave blocking structure 100, 100A or 100C, and is in the form of a flat board.

The on-road antenna 210 is set to transmit an electric wave to the vehicle 251 when the vehicle 251 reaches at a distance M1 of 30 meters from the on-road antenna 210, for instance. Since a speed per hour of a vehicle passing over an ETC toll gate is decided by a law to be equal to or smaller than 20 km/h, it can be presumed that a distance M2 between the precedent vehicle 251 and the following vehicle 253 is about 20 meters. The electromagnetic-wave blocking wall 360 is positioned in accordance with these conditions as an example.

The electromagnetic-wave blocking wall 360 is designed to have an upper end located at the same heigh as that of an upper end of the on-road antenna 210, and further designed to have a vertical length (height) H (or a position of a lower end thereof) determined as follows.

The on-road antenna 210 has a height H determined such that electric waves transmitted from the on-road antenna 210 can reach the vehicle 251 without being blocked by the electromagnetic-wave blocking wall 260, but when the reflection wave 312 coming from the following vehicle 253 is directed to the on-road antenna 210, the electromagnetic-wave blocking wall 360 blocks the reflection wave 312. That is, the height H of the electromagnetic-wave blocking wall 360 is determined such that regardless of positions of upper and lower ends of the electromagnetic-wave blocking wall 360, electric waves having been transmitted from the on-road antenna 210 can reach the precedent vehicle 251, but the electromagnetic-wave blocking wall 360 is located in a path in which the reflection wave coming from the following vehicle 253 is directing to the on-road antenna 210.

As illustrated in FIG. 14, the electromagnetic-wave blocking wall 360 has a width W equal to a width of the first traffic lane 201. Since the on-road antenna 201 is located at the center of the first traffic lane 201, the on-road antenna 210 is horizontally and entirely covered with the electromagnetic-wave blocking wall 360.

As having been explained so far, the electromagnetic-wave blocking system in accordance with the seventh exemplary embodiment prevents the reflection wave 312 coming from the following vehicle 253 from reaching the on-road antenna 210, and hence, prevents a problem caused by the reflection wave 312 coming from the following vehicle 253.

The electromagnetic-wave blocking wall 360 may be employed together with the electromagnetic-wave blocking wall 300 and/or the tunnel 350.

### INDUSTRIAL APPLICABILITY

The electromagnetic-wave blocking structure in accordance with the present invention is broadly applicable to a building material of which a nuclear shelter is made, a material of which a protective facility and/or a protective device is(are) made against EMP (electromagnetic pulse) attack, and a cover for electronic devices against EMI (electromagnetic interference), for instance.

The electromagnetic-wave blocking system using the electromagnetic-wave blocking structure is applicable further to a refuge facility for avoiding thunderbolt, as well as the above-mentioned ETC problem.

## Claims

1. A structure blocking electromagnetic waves (100), including a first portion (110) comprised of a first material consisting of an electric conductor,
**characterized by**
a second portion (120) comprised of a second material having an electrical conductivity smaller than the same of the first material and a corrosion-resistance higher than the same of the first material,
the second portion (120) covering therewith at least a part of a surface of the first portion (110).

2. The structure (100) as set forth in claim 1, wherein the first portion (110) has a first surface (111) exposed to electromagnetic waves, and a second surface (112) located in the other side of the first surface (111),
the second portion (120) covering therewith at least the first surface (111) among the first and second surfaces (111, 112),
at least the second portion (120A) among the first and second portions (110, 120) has a meshed structure.

3. The structure (100) as set forth in claim 1, wherein the first portion (110) has a first surface (111) exposed to electromagnetic waves, and a second surface (112) located in the other side of the first surface (111),
the second portion (120) covering therewith at least the first surface (111) among the first and second surfaces (111, 112),
the second portion (120B) includes at least two auxiliary mesh materials (120X, 120Y) each having a mesh pattern different from others,
the second portion (120B) covering therewith the first portion (110) in such a condition that the auxiliary mesh materials (120X, 120Y) are stacked one on another.

4. The structure (100) as set forth in claim 1, wherein the first portion (110) has a first surface (111) exposed to electromagnetic waves, and a second surface (112) located in the other side of the first surface (111),
the second portion (120) covering therewith at least the first surface (111) among the first and second surfaces (111, 112),
the second portion (120, 120C) has a first surface covering a surface (111) of the first portion (110) therewith, and a second surface located in the other side of the first surface,
the second surface being formed with convexes/concaves (113) or being wavy.

5. The structure (100) as set forth in claim 1, wherein at least one of a surface of the first portion (110) at which the first portion (110) makes contact with the second portion (120), and an outer surface of the second portion (120) has a surface roughness having a maximum height or a maximum depth shorter than a wavelength of external electromagnetic waves.

6. The structure (100B) as set forth in claim 1, wherein the first portion (110A) is in the form of a bar or a line, and the second portion (120D) covers therewith a peripheral surface of the first portion (110A).

7. The structure (100) as set forth in claim 1, wherein the first portion (110C) is formed with convexes/concaves (113) at a surface at which the first portion (110C) makes contact with the second portion (120), has a meshed structure, or has a curved surface at which the first portion (110B) makes contact with the second portion (120).

8. The structure (100) as set forth in claim 1, wherein at least one of a surface of the first portion (110C), the other surface of the first portion (110C), and an outer surface of the second portion (120C) is formed with convexes/concaves (113, 122) for electromagnetic waves to randomly reflect,
a height or a depth of the convexes/concaves (113, 122) being in the range of 1/10 to 1/50 both inclusive of a wavelength of external electromagnetic waves.

9. A system for blocking electromagnetic waves to be equipped on a traffic lane on which an electronic toll collection system is formed,
**characterized in that**
the system includes at least one of a first electromagnetic-wave blocking structure (300, 350) formed between the traffic lane (201) and a second traffic lane (202) neighboring the traffic lane (201) and a second electromagnetic-wave blocking structure (360) formed short of an on-road antenna (210) in a direction in which a vehicle (251) runs in the traffic lane (201), the on-road antenna (210) being formed above the traffic lane (201),
the first electromagnetic-wave blocking structure (300, 350) prevents electric waves transmitted from an on-road antenna (210A) located above the second traffic lane (202) and reflected from a vehicle (252) driving on the second traffic lane (202), from reaching an on-road antenna (210) located in the traffic lane (201),
the second electromagnetic-wave blocking structure (360) is located within a path in which electric waves having been transmitted from the on-road antenna (210), being able to reach a precedent vehicle (251), and having been reflected from a vehicle (253) following the precedent vehicle (251) head to the on-road antenna (210), and
the first and second electromagnetic-wave blocking structures (300, 350, 360) are comprised of the structure (100) as set forth in one of claims 1 to 8.

10. The system as set forth in claim 9, wherein the electromagnetic-wave blocking structure (300, 350) has a length equal to or greater than a length of a large-size vehicle.

11. The system as set forth in claim 9, wherein the electromagnetic-wave blocking structure is in the form of a wall (300).

12. The system as set forth in claim 11, wherein the wall (300) has a height higher than the on-road antenna (210) transmitting electric waves to a vehicle (251) driving on the traffic lane (201).

13. The system as set forth in claim 11, wherein the wall (300) has such a length along the traffic lane (201) that the on-road antenna (210) formed on the traffic lane (201) is located within the wall (300).

14. The system as set forth in claim 9, wherein the electromagnetic-wave blocking structure is in the form of a tunnel (350) covering the traffic lane (201) therewith.

15. The system as set forth in claim 14, wherein the tunnel (350) has such a length along the traffic lane (201) that the on-road antenna (210) formed on the traffic lane (201) is located within the tunnel (350).
